# EUROPEAN PATENT APPLICATION

(11) **EP 3 591 716 A1**
(43) Date of publication of application: **08.01.2020**
(21) Application number: 17898467.0
(22) Date of filing: 24.06.2017
(51) Int. Cl.: H01L 31/0236, H01L 31/068, H01L 31/18

(54) **P-TYPE PERC DOUBLE-SIDED SOLAR CELL BENEFICIAL TO SUNLIGHT ABSORPTION AND PREPARATION METHOD THEREFOR**

(30) Priority: 03.03.2017 CN 201710123845
(71) Applicant: Guangdong Aiko Solar Energy Technology Co., Ltd., Foshan, Guangdong 528000 (CN); Zhejiang Aiko Solar Enery Technology Co., Ltd., Yiwu, Zhejiang 322009 (CN)
(72) Inventor: LIN, Kang-Cheng, Foshan, Guangdong 528000 (CN); FANG, Jiebin, Foshan, Guangdong 528000 (CN); CHEN, Gang, Foshan, Guangdong 528000 (CN)
(74) Representative: Kudlek, Franz Thomas
(86) International application number: PCT/CN2017/089885
(87) International publication number: WO 2018/157522

(57) **Abstract**

A bifacial P-type PERC solar cell beneficial to sunlight absorption and a preparation method therefor are provided. The solar cell includes consecutively, from the bottom up, a rear electrode (1), a rear silicon nitride film (3), a rear alumina film (4), a P-type silicon (5), an N-type silicon (6), a front silicon nitride film (7) and a front silver electrode (8), wherein a front surface of the P-type silicon is provided with a plurality of parallel grooves (10) which are exposed to the front silicon nitride film. A length direction of a groove of the grooves is parallel to a front silver busbar electrode (81), and an inner surface of the groove is a textured surface which can receive sunlight incident from different directions and capture the sunlight through multiple reflections and incidences inside the groove. By etching a plurality of grooves in the front surface of the cell silicon wafer, the solar cell can capture more sunlight and improve the absorption rate for sunlight, thereby increasing the amount of power generated by a fixed bracket photovoltaic system for bifacial cells and a single-axis tracking photovoltaic system for bifacial cells. There is further provided a method of preparing the solar cell.

## Description

### FIELD

The present invention relates to the field of solar cells, and in particular to a bifacial P-type PERC solar cell beneficial to sunlight absorption and a preparation method therefor.

### BACKGROUND

A crystalline silicon solar cell is a device that effectively absorbs solar radiation energy and converts light energy into electrical energy through the photovoltaic effect. When sunlight reaches the p-n junction of a semiconductor, new electron-hole pairs are generated. Under the action of the electric field of the p-n junction, the holes flow from the N zone to the P zone, and the electrons flow from the P zone to the N zone, generating current upon switching on a circuit.

In a conventional crystalline silicon solar cell, surface passivation is basically only performed at the front surface, which involves depositing a layer of silicon nitride on the front surface of the silicon wafer via PECVD to reduce the recombination rate of the minority carriers at the front surface. As a result, the open-circuit voltage and short-circuit current of the crystalline silicon cell can be greatly increased, which leads to an increase of the photoelectric conversion efficiency of the crystalline silicon solar cell.

As the requirements for the photoelectric conversion efficiency of crystalline silicon cells become increasingly higher, people have been researching rear-surface passivation techniques for PERC solar cells. Nowadays, mainstream manufacturers in the industry are focused on mass production of monofacial PERC solar cells, but for the bifacial PERC solar cells, there are only researches in laboratories of some research institutes. Bifacial PERC solar cells have higher usage values in the practical applications as they have high photoelectric conversion efficiency while absorbing sunlight on both sides to generate more power.

When the sun shines directly on a solar cell, the solar cell absorbs energy to the maximum level. In a fixed bracket photovoltaic system, because a solar cell is oriented in a fixed direction, the solar cell receives sunlight at different angles as movement of the sun in a day, so that the solar energy absorbed is highly unstable. A single-axis tracking photovoltaic system is unable to well track the angle of sunlight, thus still failing to absorb the solar energy to the greatest extent.

In order to overcome the deficiency, the bifacial PERC solar cell should be optimized correspondingly, and it is required to improve the sunlight absorption rate of the bifacial PERC solar cell in the fixed bracket photovoltaic system and the single-axis tracking photovoltaic system, thus increasing the amount of power generated by the fixed bracket photovoltaic system and the single-axis tracking photovoltaic system for the bifacial PERC solar cell.

### SUMMARY

One objective of the present invention is to provide a bifacial P-type PERC solar cell beneficial to sunlight absorption, which captures more sunlight by etching a plurality of grooves on the front surface of the cell silicon wafer, thus improving the absorption rate for sunlight and increasing the amount of power generated by the fixed bracket photovoltaic system for the bifacial cell and the single-axis tracking photovoltaic system for the bifacial cell.

This objective of the present invention may be accomplished through the following technical solution: a bifacial P-type PERC solar cell beneficial to sunlight absorption, comprising: consecutively, from the bottom up, a rear electrode, a rear silicon nitride film, a rear alumina film, a P-type silicon, an N-type silicon, a front silicon nitride film and a front silver electrode, wherein the P-type silicon is a silicon wafer of the cell, the N-type silicon is an N-type emitter formed through diffusion via a front surface of the silicon wafer, the front silver electrode is comprised of a front silver busbar electrode with a material of silver and a front silver finger electrode with a material of silver which is perpendicular to the front silver busbar electrode, and the rear electrode is comprised of rear silver busbar electrodes with a material of silver and rear aluminum finger electrodes with a material of aluminum which are perpendicular to the rear silver busbar electrodes, wherein a rear surface of the solar cell is further provided with laser grooving regions running through the rear silicon nitride film and the rear alumina film to the P-type silicon, an aluminum paste is printed and poured into the laser grooving regions, forming rear aluminum strips, the rear aluminum finger electrodes are printed integrally with the rear aluminum strips in the laser grooving regions and are connected with the P-type silicon via the rear aluminum strips, characterized in that: a front surface of the P-type silicon is provided with a plurality of parallel grooves which are exposed to the front silicon nitride film, wherein a length direction of each groove of the grooves is parallel to the front silver busbar electrode, and an inner surface of the groove is a textured surface which can receive sunlight incident from different directions and capture the sunlight through multiple reflections and incidences inside the groove.

In the solar cell according to the present invention, a plurality of parallel grooves are etched in the front surface of the cell. In a bifacial cell fixed bracket photovoltaic system, although the front surface of the cell is oriented in a fixed direction, due to the grooves etched therein, the textured structure in the grooves can receive sunlight incident from different directions and capture the sunlight through multiple reflections and incidences inside the grooves, to bring about an increase in sunlight absorption in a fixed bracket photovoltaic system and a single-axis tracking photovoltaic system and a rise in the amount of power generated by a fixed bracket photovoltaic system and a single-axis tracking photovoltaic system for the bifacial cell.

In the present invention, the groove may be of the following structures:

The groove is a continuous linear slot or a discontinuous line-segment slot, each segment of the line-segment slot has a length of 10-60 µm.

The groove has a cross section of an oblong, square, V-like, pentagonal or hexagonal shape and a depth of 5-20 µm. In the plurality of parallel grooves, adjacent grooves are spaced with a distance of 1-20 mm.

The rear silicon nitride film has a thickness of 20-500 nm.

The rear alumina film has a thickness of 2-50 nm.

A number of the rear aluminum finger electrodes is 30-500, preferably 80-220.

The rear silver busbar electrodes each are a continuous straight line or a segmented line.

In the present invention, a number of the laser grooving regions is greater than one, the laser grooving regions each have a line segment-like, straight line-like, dotted line-like, or dot-like pattern, the laser grooving regions each have a width of 10-500 µm, and adjacent laser grooving regions are spaced with a distance of 0.5-10 mm.

The present invention may include an improvement that: an periphery of the rear electrode is further printed with a ring of outer aluminum frame with a material of aluminum, the outer aluminum frame is connected with the corresponding rear silver busbar electrodes and rear aluminum finger electrodes, respectively, and the outer aluminum frame is to provide an additional transmission path for electrons.

In the solar cell printing process, due to a high viscosity of the aluminum paste and a narrow line width of the printing screen, a broken aluminum finger line occurs sometimes. The broken aluminum finger line may result in a black broken finger in the image of the EL test and impact the photoelectric conversion efficiency of the cell. The rear electrode according to the present invention at its periphery is additionally provided with a ring of outer aluminum frame for providing an additional transmission path for electrons, thus avoiding the problems of broken fingers EL testing due to the broken aluminum fingers and low photoelectric conversion efficiency. The outer aluminum frame is connected with the corresponding rear silver busbar electrodes and rear aluminum finger electrodes, respectively. A laser grooving region may be provided below the aluminum outer frame which is connected with the P-type silicon via the laser grooving region. The outer aluminum frame may also be provided without the laser grooving region.

As compared with the prior art, experiments show that, by etching a plurality of parallel grooves in the front surface of the silicon wafer, the solar cell according to the present invention can increase sunlight absorption of the fixed bracket photovoltaic system and the single-axis tracking photovoltaic system; and specifically, the sunlight absorption rate can be increased by 3%-8%, and the amount of power generated by the fixed bracket photovoltaic system and the single-axis tracking photovoltaic system for bifacial cells can be promoted by 2%-6%.

The second objective of the present invention is to provide a method of preparing the bifacial P-type PERC solar cell beneficial to absorb sunlight as described above.

This objective of the present invention may be achieved through the following technical solution: the method of preparing the bifacial P-type PERC solar cell beneficial to sunlight absorption as described above, characterized by comprising steps of:
(1) performing laser grooving in a front surface of a silicon wafer, to provide a plurality of parallel grooves, wherein the silicon wafer is a P-type silicon;
(2) wet texturing the front surface and a rear surface of the silicon wafer, to form textured surfaces, wherein inner surfaces of the grooves are textured surfaces;
(3) performing diffusion via the front surface of the silicon wafer, to form an N-type silicon that is an N-type emitter;
(4) removing phosphosilicate glass and peripheral PN junctions formed during the diffusion;
(5) polishing the rear surface of the silicon wafer;
(6) depositing a rear alumina film on the rear surface of the silicon wafer;
(7) depositing a rear silicon nitride film on a rear surface of the alumina film;
(8) depositing a front silicon nitride film on a front surface of the N-type silicon, wherein the grooves are exposed to the front silicon nitride film;
(9) performing laser grooving in the rear surface of the silicon wafer, to form a laser grooving region running through the rear silicon nitride film and rear alumina film to the silicon wafer;
(10) printing, using screen printing, a rear silver busbar electrode of a rear electrode on the rear surface of the silicon wafer;
(11) printing, using screen printing, a rear aluminum finger electrode on the rear surface of the silicon wafer, while printing an aluminum paste in the laser grooving region, to form a rear aluminum strip, wherein the rear aluminum strip is printed integrally with the rear aluminum finger electrode;
(12) printing, using screen printing or in an ink jet manner, a front electrode paste on a front surface of the front silicon nitride film, to form a front silver busbar electrode and a front silver finger electrode, wherein a length direction of the grooves is parallel to the front silver busbar electrode;
(13) sintering the silicon wafer at a high temperature, to form the rear electrode and a front silver electrode; and
(14) annealing the silicon wafer in an anti-LID manner to obtain the solar cell.

Wherein, the step (8) of depositing the front silicon nitride film on the front surface of the N-type silicon may precede the step (6) of depositing the alumina film on the rear surface of the silicon wafer, and the step (5) is optional.

The preparation method may include a further laser grooving process before texturing, in which a plurality of parallel grooves are etched in the front surface of the cell, to increase sunlight absorption of a fixed bracket photovoltaic system and a single-axis tracking photovoltaic system, and increase the amount of power generated by the fixed bracket photovoltaic system and single-axis tracking photovoltaic system for bifacial cells.

Moreover, the preparation method can be implemented conveniently, the corresponding device requires a low investment, and the process is simple and well compatible with the current production line.

### BRIEF DESCRIPTION OF THE DRAWINGS

The present invention is further detailed below in combination with the drawings and specific embodiments.
FIG. 1 is a sectional view of an overall structure of a bifacial P-type PERC solar cell beneficial to sunlight absorption of the present invention;
FIG. 2 is a plan view of a front side of a bifacial P-type PERC solar cell beneficial to sunlight absorption of the present invention;
FIG. 3 is a plan view of a rear side of a bifacial P-type PERC solar cell beneficial to sunlight absorption of the present invention;
FIG. 4 is a plan view of a rear side with another structure in a bifacial P-type PERC solar cell beneficial to sunlight absorption of the present invention;
FIG. 5 is a plan view of a rear side with a further structure in a bifacial P-type PERC solar cell beneficial to sunlight absorption of the present invention; and
FIG. 6 is a plan view of a rear side with a still further structure in a bifacial P-type PERC solar cell beneficial to sunlight absorption of the present invention.

Reference signs contained herein are listed below:
1. rear electrode; 11. rear silver busbar electrode; 12. rear aluminum finger electrode; 2. laser grooving region; 3. rear silicon nitride film; 4. rear alumina film; 5. P-type silicon; 6. N-type silicon; 7. front silicon nitride film; 8. front silver electrode; 81. front silver busbar electrode; 82. front silver finger electrode; 9. rear aluminum strip; 10. groove; 20. outer aluminum frame.

### DETAILED DESCRIPTION OF EMBODIMENTS

### Embodiment 1

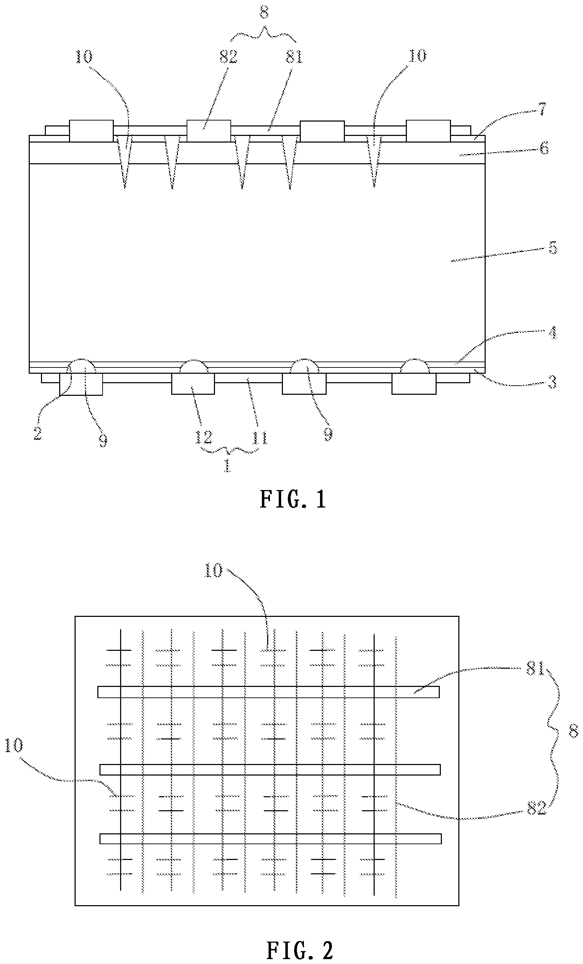

A bifacial P-type PERC solar cell beneficial to sunlight absorption as shown in FIGS. 1-3 includes consecutively, from the bottom up, a rear electrode 1, a rear silicon nitride film 3, a rear alumina film 4, a P-type silicon 5, an N-type silicon 6, a front silicon nitride film 7 and a front silver electrode 8, where the P-type silicon 5 is a silicon wafer of the cell, the N-type silicon 6 is an N-type emitter formed through diffusion via the front surface of the silicon wafer, the front silver electrode 8 is comprised of a front silver busbar electrode 81 with a material of silver and a front silver finger electrode 82 with a material of silver which is perpendicular to the front silver busbar electrode 81, and the rear electrode 1 is comprised of a rear silver busbar electrode 11 with a material of silver and a rear aluminum finger electrode 12 with a material of aluminum which is perpendicular to the rear silver busbar electrode 11.

The rear surface of the solar cell is provided with a laser grooving region 2 running through the rear silicon nitride film 3 and the rear alumina film 4 to the P-type silicon 5. The laser grooving region 2 is arranged in parallel to the rear aluminum finger electrode 12. Aluminum paste is printed and poured into the laser grooving region 2, forming a rear aluminum strip 9. The rear electrode 1 is comprised of the rear silver busbar electrode 11 with a material of silver and the rear silver finger electrode 12 with a material of aluminum. The rear aluminum finger electrode 12 is printed integrally with the rear aluminum strip 9 in the laser grooving region 2 and is connected with the P-type silicon 5 via the rear aluminum strip 9.

A front surface of the P-type silicon 5 is provided with a plurality of parallel grooves 10. The groove 10 is exposed to the front silicon nitride film 7 and has a length direction parallel to the front silver busbar electrode 81. An inner surface of the groove 10 is a textured surface which can receive sunlight incident from different directions and capture the sunlight through multiple reflections and incidences inside the groove.

In the solar cell, a plurality of parallel grooves 10 are etched in the front surface of the cell. In a fixed bracket photovoltaic system and a single-axis tracking photovoltaic system for the bifacial cell, although the front surface of the cell is oriented in a fixed direction, due to the grooves 10 etched therein, the textured structure in the grooves 10 can receive sunlight incident from different directions and capture the sunlight through multiple reflections and incidences inside the grooves 10 to increase the absorption rate for sunlight, thereby bringing about an increase in sunlight absorption in a fixed bracket photovoltaic system and a single-axis tracking photovoltaic system, and a rise in the amount of power generated by a fixed bracket photovoltaic system and a single-axis tracking photovoltaic system for the bifacial cell.

The groove 10 in the embodiment is a discontinuous line-segment slot, in which each segment of the line-segment slot has a length of 50 µm. The groove 10 has a V-shaped cross section and a depth of 15 µm. In the plurality of parallel grooves 10, adjacent grooves 10 are spaced with a distance of 10 mm.

As a variant of the present embodiment, the groove may be a continuous linear slot or discontinuous line-segment slot. If it is a discontinuous line-segment slot, each segment of the line-segment slot has a length of 10-60 µm. The groove may also have a cross section of an oblong, square, pentagonal or hexagonal shape, and have a depth of 5-20 µm. In the plurality of parallel grooves, adjacent grooves are spaced with a distance of 1-20 mm.

The rear aluminum strip 9 in the present embodiment is printed integrally with the rear aluminum finger electrode 12, and practically is a part of the rear aluminum finger electrode 12. When the rear aluminum finger electrode 12 is printed, the aluminum paste will flow into the laser grooving region 2, forming the rear aluminum strip 9.

The rear alumina film 4 of the present embodiment has a material of aluminum oxide (Al₂O₃). The rear silicon nitride film 3 and the front silicon nitride film 7 are formed of the same material, namely silicon nitride (Si₃N₄). The pattern of the laser grooving region 2 is linear, which may also be line segment-like, dotted line-like, or dot-like. The width of the laser grooving region 2 is 30 µm, which may also be selected from 10-500 µm, preferably 30-60 µm.

In the present embodiment, the rear silver busbar electrode 11 is a continuous straight line, a number of the rear aluminum finger electrodes 12 is 150, the rear silicon nitride film 3 has a thickness of 20 nm, and the rear alumina film 4 has a thickness of 2 nm. The thickness of the rear silicon nitride film 3 may also be selected from 20-500 nm, such as 200 nm, 300 nm, 400 nm or the like, and the thickness of the rear alumina film 4 may also be selected from 2-50 nm, such as 20 nm, 30 nm, 40 nm, or the like.

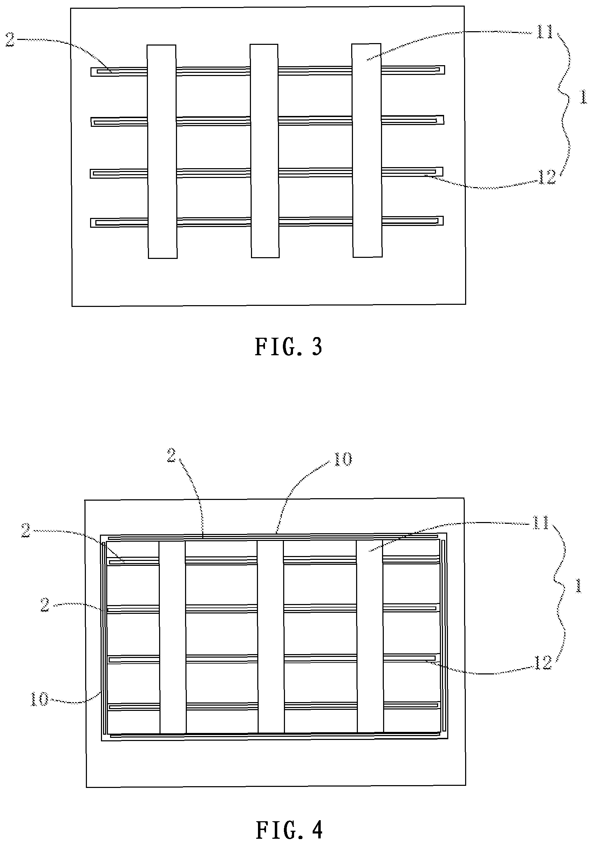

As an improvement to the rear electrode as shown in FIG. 3, the rear electrode may also be of the structure as shown in FIG. 4 where the periphery of the rear electrode is printed with a ring of outer aluminum frame 20 formed of aluminum. The outer aluminum frame 20 is connected with the corresponding rear silver busbar electrode 11 and rear aluminum finger electrode 12, respectively. The outer aluminum frame 20 provides an additional transmission path for electrons, thereby avoiding the problems of broken fingers EL testing due to broken aluminum fingers and low photoelectric conversion efficiency. In FIG. 4, a laser grooving region 2 is also provided below and in parallel to the outer aluminum frame 20 which is connected with the P-type silicon via the laser grooving region 2. The outer aluminum frame 20 may be provided without the laser grooving region 2. The outer aluminum frame 20 as shown in FIG. 4 is a rectangular frame, which is connected with a corresponding plurality of rear silver busbar electrodes 11 and rear aluminum finger electrodes 12, respectively. The outer aluminum frame 20 may also be of a structure selected according to the shape of the rear electrode and fitted with the latter, for example, an oblong frame, square frame, round frame, oval frame, or the like.

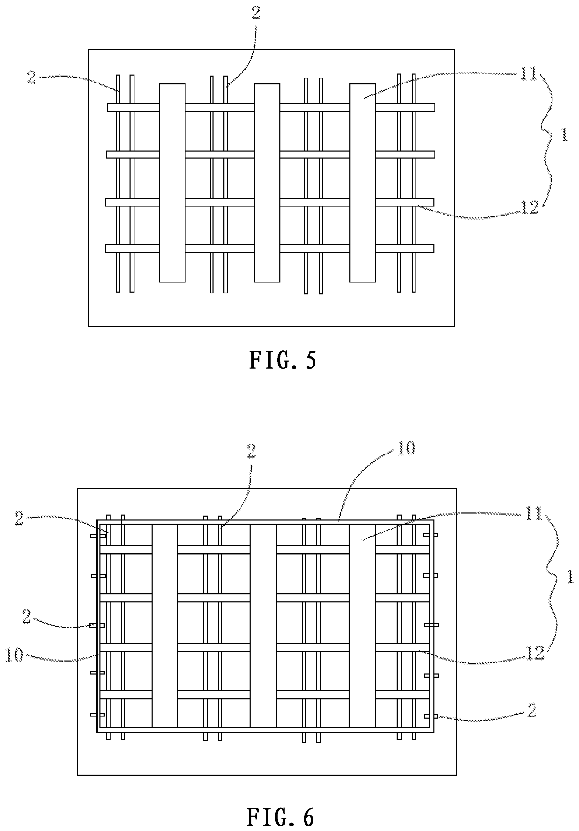

As a variant of the present embodiment, the rear electrode may be of a structure as shown in FIG. 5 where the laser grooving region 2 is arranged perpendicular to the rear aluminum finger electrode 12 and has a pattern of a straight line, and a number of the laser grooving regions 2 is greater than one. The adjacent laser grooving regions are spaced with a distance of 0.9 mm, which may also be selected from 0.5-10 mm, preferably 0.8-1 mm.

As an improvement to the rear electrode as shown in FIG. 5, the rear electrode may be of a structure as shown in FIG. 6 where the periphery of the rear electrode is printed with a ring of outer aluminum frame 20 formed of aluminum. The outer aluminum frame 20 is connected with the corresponding rear silver busbar electrode 11 and rear aluminum finger electrode 12, respectively. In FIG. 6, a laser grooving region 2 is also provided below and perpendicular to the outer aluminum frame 20 which is connected with the P-type silicon via the laser grooving region 2. The outer aluminum frame 20 may also be provided without the laser grooving region 2.

A method of preparing the above bifacial P-type PERC solar cell beneficial to sunlight absorption includes steps of:
(1) performing laser grooving in a front surface of a silicon wafer, to provide a plurality of parallel grooves 10, wherein the silicon wafer is a P-type silicon 5;
(2) wet texturing the front surface and a rear surface of the silicon wafer, to form textured surfaces, wherein inner surfaces of the grooves 10 are also textured surfaces;
(3) performing diffusion via the front surface of the silicon wafer, to form an N-type silicon 6, i.e., an N-type emitter;
(4) removing phosphosilicate glass and peripheral PN junctions formed during the diffusion;
(5) polishing the rear surface of the silicon wafer;
(6) depositing a rear alumina film 4 on the rear surface of the silicon wafer;
(7) depositing a rear silicon nitride film 3 on a rear surface of the alumina film;
(8) depositing a front silicon nitride film 7 on a front surface of the N-type silicon 6, wherein the grooves 10 are exposed to the front silicon nitride film 7;
(9) performing laser grooving in the rear surface of the silicon wafer, to form a laser grooving region 2 running through the rear silicon nitride film 3 and rear alumina film 4 to the silicon wafer;
(10) printing, using screen printing, a rear silver busbar electrode 11 of a rear electrode 1 on the rear surface of the silicon wafer;
(11) printing, using screen printing, a rear aluminum finger electrode 12 on the rear surface of the silicon wafer, and printing an aluminum paste in the laser grooving region 2 while printing the rear aluminum finger electrode 12, to form a rear aluminum strip 9, wherein the rear aluminum strip 9 is printed integrally with the rear aluminum finger electrode 12, the rear aluminum strip 9 is practically a part of the rear aluminum finger electrode 12, and the aluminum paste flows into the laser grooving region 2 when the rear aluminum finger electrode 12 is printed, thereby forming the rear aluminum strip 9;
(12) printing, using screen printing or in an ink jet manner, a front electrode paste on a front surface of the front silicon nitride film 7, to form a front silver busbar electrode 81 and a front silver finger electrode 82, wherein a length direction of the groove 10 is parallel to the front silver busbar electrode 81;
(13) sintering the silicon wafer at a high temperature, to form the rear electrode 1 and a front silver electrode 8; and
(14) annealing the silicon wafer in an anti-LID manner to obtain the solar cell.

Wherein, the step (8) of depositing a front silicon nitride film 7 on a front surface of the N-type silicon 6 may also precede the step (6) of depositing a rear alumina film 4 on the rear surface of the silicon wafer, and the step (5) may also be omitted.

### Embodiment 2

Embodiment 2 of the bifacial P-type PERC solar cell beneficial to sunlight absorption of the present invention is different from Embodiment 1 in that: in Embodiment 2, the rear silver busbar electrode 11 is a segmented line, the number of the rear aluminum finger electrodes 12 is 100, the rear silicon nitride film 3 has a thickness of 150 nm, and the rear alumina film 4 has a thickness of 6 nm.

### Embodiment 3

Embodiment 3 of the bifacial P-type PERC solar cell beneficial to sunlight absorption of the present invention is different from Embodiment 1 in that: in Embodiment 3, the rear silver busbar electrode 11 is a continuous straight line, the number of the rear aluminum finger electrodes 12 is 180, the rear silicon nitride film 3 has a thickness of 140 nm, and the rear alumina film 4 has a thickness of 15 nm.

### Embodiment 4

Embodiment 4 of the bifacial P-type PERC solar cell beneficial to sunlight absorption of the present invention is different from Embodiment 1 in that: in Embodiment 4, the rear silver busbar electrode 11 is a segmented line, the number of the rear aluminum finger electrodes 12 is 250, the rear silicon nitride film 3 has a thickness of 180 nm, and the rear alumina film 4 has a thickness of 25 nm.

### Embodiment 5

Embodiment 5 of the bifacial P-type PERC solar cell beneficial to sunlight absorption of the present invention is different from Embodiment 1 in that: in Embodiment 5, the rear silver busbar electrode 11 is a continuous straight line, the number of the rear aluminum finger electrodes 12 is 500, the rear silicon nitride film 3 has a thickness of 500 nm, and the rear alumina film 4 has a thickness of 50 nm.

The above embodiments of the present invention are not intended to limit the protection scope of the present invention, to which the implementations of the present invention are not confined. Many other forms of modifications, substitutions or alternations made to the above structure of the present invention, which are provided on the basis of the above content of the present invention in view of the common technical knowledge and customary means in the art, shall all fall into the protection scope of the present invention, without departing from the basic technical idea as described above of the present invention.

## Claims

1. A bifacial P-type PERC solar cell beneficial to sunlight absorption, comprising: consecutively, from the bottom up, a rear electrode, a rear silicon nitride film, a rear alumina film, a P-type silicon, an N-type silicon, a front silicon nitride film and a front silver electrode, wherein the P-type silicon is a silicon wafer of the cell, the N-type silicon is an N-type emitter formed through diffusion via a front surface of the silicon wafer, the front silver electrode is comprised of a front silver busbar electrode with a material of silver and a front silver finger electrode with a material of silver which is perpendicular to the front silver busbar electrode, and the rear electrode is comprised of rear silver busbar electrodes with a material of silver and rear aluminum finger electrodes with a material of aluminum which are perpendicular to the rear silver busbar electrodes, wherein a rear surface of the solar cell is further provided with laser grooving regions running through the rear silicon nitride film and the rear alumina film to the P-type silicon, an aluminum paste is printed and poured into the laser grooving regions, forming rear aluminum strips, the rear aluminum finger electrodes are printed integrally with the rear aluminum strips in the laser grooving regions and are connected with the P-type silicon via the rear aluminum strips, **characterized in that**: a front surface of the P-type silicon is provided with a plurality of parallel grooves which are exposed to the front silicon nitride film, wherein a length direction of each groove of the grooves is parallel to the front silver busbar electrode, and an inner surface of the groove is a textured surface which can receive sunlight incident from different directions and capture the sunlight through multiple reflections and incidences inside the groove.

2. The bifacial P-type PERC solar cell beneficial to sunlight absorption of claim 1, **characterized in that**: the groove is a continuous linear slot or a discontinuous line-segment slot, each segment of the line-segment slot has a length of 10-60 µm.

3. The bifacial P-type PERC solar cell beneficial to sunlight absorption of claim 1, **characterized in that**: the groove has a cross section of an oblong, square, V-like, pentagonal or hexagonal shape and a depth of 5-20 µm.

4. The bifacial P-type PERC solar cell beneficial to sunlight absorption of claim 1, **characterized in that**: in the plurality of parallel grooves, adjacent grooves are spaced with a distance of 1-20 mm.

5. The bifacial P-type PERC solar cell beneficial to sunlight absorption of claim 1, **characterized in that**: the rear silicon nitride film has a thickness of 20-500 nm, and the rear alumina film has a thickness of 2-50 nm.

6. The bifacial P-type PERC solar cell beneficial to sunlight absorption of claim 1, **characterized in that**: the rear sliver busbar electrodes each are a continuous straight line or a segmented line, and a number of the rear aluminum finger electrodes is 30-500.

7. The bifacial P-type PERC solar cell beneficial to sunlight absorption of claim 2, **characterized in that**: a number of the laser grooving regions is greater than one, the laser grooving regions each have a line segment-like, straight line-like, dotted line-like, or dot-like pattern.

8. The bifacial P-type PERC solar cell beneficial to sunlight absorption of claim 7, **characterized in that**: the laser grooving regions each have a width of 10-500 µm, and adjacent laser grooving regions are spaced with a distance of 0.5-10 mm.

9. The bifacial P-type PERC solar cell beneficial to sunlight absorption of any of claims 1-8, **characterized in that**: an periphery of the rear electrode is printed with a ring of outer aluminum frame with a material of aluminum, the outer aluminum frame is connected with the corresponding rear silver busbar electrodes and rear aluminum finger electrodes, respectively, and the outer aluminum frame is to provide an additional transmission path for electrons.

10. A method of preparing the bifacial P-type PERC solar cell beneficial to sunlight absorption of any of claims 1-9, **characterized by** comprising steps of:
(1) performing laser grooving in a front surface of a silicon wafer, to provide a plurality of parallel grooves, wherein the silicon wafer is a P-type silicon;
(2) wet texturing the front surface and a rear surface of the silicon wafer, to form textured surfaces, wherein inner surfaces of the grooves are textured surfaces;
(3) performing diffusion via the front surface of the silicon wafer, to form an N-type silicon that is an N-type emitter;
(4) removing phosphosilicate glass and peripheral PN junctions formed during the diffusion;
(5) polishing the rear surface of the silicon wafer;
(6) depositing a rear alumina film on the rear surface of the silicon wafer;
(7) depositing a rear silicon nitride film on a rear surface of the alumina film;
(8) depositing a front silicon nitride film on a front surface of the N-type silicon, wherein the grooves are exposed to the front silicon nitride film;
(9) performing laser grooving in the rear surface of the silicon wafer, to form a laser grooving region running through the rear silicon nitride film and rear alumina film to the silicon wafer;
(10) printing, using screen printing, a rear silver busbar electrode of a rear electrode on the rear surface of the silicon wafer;
(11) printing, using screen printing, a rear aluminum finger electrode on the rear surface of the silicon wafer, while printing an aluminum paste in the laser grooving region, to form a rear aluminum strip, wherein the rear aluminum strip is printed integrally with the rear aluminum finger electrode;
(12) printing, using screen printing or in an ink jet manner, a front electrode paste on a front surface of the front silicon nitride film, to form a front silver busbar electrode and a front silver finger electrode, wherein a length direction of the grooves is parallel to the front silver busbar electrode;
(13) sintering the silicon wafer at a high temperature, to form the rear electrode and a front silver electrode; and
(14) annealing the silicon wafer in an anti-LID manner to obtain the solar cell;
wherein the step (5) can be optional.
